# EUROPÄISCHE PATENTSCHRIFT

(11) **EP 2 836 439 B1**
(45) Veröffentlichungstag und Bekanntmachung des Hinweises auf die Patenterteilung: **07.06.2017**
(21) Anmeldenummer: 13700705.0
(22) Anmeldetag: 16.01.2013
(51) Int. Cl.: H05H 1/34, H01J 37/32, C23C 16/04, C23C 16/513

(54) **BESCHICHTUNG VON BEHÄLTERN MIT PLASMADÜSEN**
COATING CONTAINERS USING PLASMA NOZZLES
REVÊTEMENT DE RÉCIPIENTS AU MOYEN DE BUSES À PLASMA

(30) Priorität: 13.04.2012 DE 102012206081
(43) Veröffentlichungstag der Anmeldung: 18.02.2015
(73) Patentinhaber: Krones AG, 93073 Neutraubling (DE)
(72) Erfinder: KRUEGER, Jochen, 93073 Neutraubling (DE); HUMELE, Heinz, 93073 Neutraubling (DE)
(74) Vertreter: Grünecker Patent- und Rechtsanwälte PartG mbB
(86) Internationale Anmeldenummer: PCT/EP2013/050707
(87) Internationale Veröffentlichungsnummer: WO 2013/152872

(56) Entgegenhaltungen:
- WO-A2-2006/004399
- DE-T2- 60 222 391
- US-A- 4 606 942
- US-A1- 2005 127 843
- US-B1- 6 465 964
- HIDEYUKI KODAMA ET AL: "Synthesis of Practical High-Gas-Barrier Carbon Films at Low and Atmospheric Pressure for PET Bottles", NEW DIAMOND AND FRONTIER CARBON TECHNOLOGY, Bd. 16, Nr. 2, 1. Januar 2006 (2006-01-01) , Seiten 107-119, XP055073061,
- TENDERO ET AL: "Atmospheric pressure plasmas: A review", SPECTROCHIMICA ACTA. PART B: ATOMIC SPECTROSCOPY, NEW YORK, NY, US, US, Bd. 61, Nr. 1, 1. Januar 2006 (2006-01-01) , Seiten 2-30, XP005288077, ISSN: 0584-8547, DOI: 10.1016/J.SAB.2005.10.003

## Beschreibung

### Stand der Technik

Zur Verminderung der Durchlässigkeit von Behälter-/Hohlkörperwänden, z.B. in Bezug auf unerwünschte Stoffe, ist es vorteilhaft, diese mit einer Barriereschicht zu versehen, beispielsweise durch plasmaunterstützte chemische Gasphasenabscheidung/Plasma Enhanced Chemical Vapor Depositon (PECVD), wie z.B. in der EP0881197A2 beschrieben.

Solche Barriereschichten werden z.B. benötigt um die Transmissionsraten von Gasen durch die Kunststoffwand eines Behälters zu reduzieren. Auf diese Weise kann beispielsweise der Verlust von CO₂ aus dem eingefüllten Produkt oder der Eintrag von Sauerstoff in das Produkt minimiert werden. Auch kann das Produkt so vor Stoffen geschützt werden, die aus dem Behältermaterial kommen und das Produkt farblich oder geschmacklich verändern können.

Zur Beschichtung von Behältnissen mittels Plasmabehandlung, beispielsweise der Plasmainnenbeschichtung von Kunststoffflaschen, kann unter anderem ein sogenanntes Hochfrequenzplasma in sogenannten Niederdruck-Anlagen eingesetzt werden.

Dabei wird zunächst das Innere des Behälters auf einen Druck im Bereich von 1-10 Pa evakuiert. In den Bereich der zu beschichtenden Oberfläche, z.B. dem Behälterinneren, wird dann ein Prozessgas eingeleitet, aus dem die Schicht gebildet wird, der sogenannte "Precursor", wodurch sich der Druck im Inneren des Behälters auf 10 - 30 Pa erhöhen kann.

Dieses Gas oder Gasgemisch kann dann mit Hilfe elektromagnetischer Strahlung, z.B. Mikrowelle oder Hochfrequenz oder anderer elektrischer Felder teilweise oder vollständig in einen Plasmazustand versetzt und dabei in seine Bestandteile zerlegt werden. Teile des Gases reagieren plasmaunterstützt in der Gasphase oder an der Oberfläche des zu beschichtenden Substrates, z.B. der Innenwand einer Kunststoffflasche, und kondensieren an dieser Oberfläche zu einer geschlossenen Schicht.

Nachteilig an dieser Beschichtungstechnik ist unter anderem die aufwändige Vakuumtechnik, die hierzu benötigt wird und auch die mitunter nicht unerhebliche thermische Belastung des Substrates, kritisch vor allem bei Kunststoffoberflächen, da diese so beschädigt werden können.

Es sind inzwischen Plasmaquellen bekannt, die ein Plasma unter Umgebungsdruck erzeugen können, sogenannte Plasmadüsen, wie z.B. beschrieben in der EP1335641, der US2007116891, der EP0761415 und der US20020179575.

### Aufgabe

Es ist somit Aufgabe der Erfindung eine Vorrichtung zur Beschichtung von Behältern und/oder Behälterformen mittels Plasmabehandlung, beispielsweise der Beschichtung von Kunststoffflaschen und/oder Behältervorformen, zu verbessern, insbesondere hinsichtlich Minimierung der Komplexität und Effizienz der Beschichtungsvorrichtung.

### Lösung

Dies wird erfindungsgemäß durch eine Vorrichtung nach Anspruch 1 und einem Verfahren nach Anspruch 10 erreicht. Vorteilhafte Ausführungsformen und Weiterbildungen sind Gegenstand der Unteransprüche.

Eine erfindungsgemäße Vorrichtung zur plasmaunterstützten Beschichtung eines Behälters, beispielsweise einer Kunststoffflasche, und/oder einer Behältervorform, z.B. eines Vorformlings, beinhalted wenigstens eine Hochfrequenzquelle, wenigstens eine Gaszufuhr zur Zufuhr von Prozessgas, und wenigstens eine Plasmadüse als Plasmaquelle. Die Plasmaquelle weist dabei eine innere Elektrode auf, und die innere Elektrode ist von einem Düsenrohr umgeben. Darüber ist die wenigstens eine Plasmaquelle in einen zu beschichtenden Behälter einführbar und so konfiguriert, dass sie dass Prozessgas teilweise oder vollständig in ein Plasma unter Umgebungsdruck, beispielsweise in einem Druckbereich von 800 bis 1200 hPa, umsetzen kann, und das Plasma aus einem Düsenrohrende austreten kann, und wobei die Temperatur des erzeugten Plasmas im Bereich der Umgebungstemperatur, z.B. zwischen 10 und 50 °C, liegt. Das Düsenrohr der Plasmaquelle weist ein longitudinales Düsenrohrelement und ein seitliches Düsenrohrelement auf, wobei das seitliche Düsenrohrelement seitlich vom longitudinalen Düsenrohrelement abragt, und Plasma durch das seitlichen Düsenrohrende austreten kann.

Dies hat den Vorteil, dass eine sonst übliche aufwändige und umständliche Vakuumerzeugung im Plasmabehandlungsbereich, z.B. innerhalb und/oder außerhalb eines zu beschichtenden Behälters vermieden werden kann, sowie die thermische Belastung des zu beschichtenden Substrats, beispielsweise einer Kunststoffflasche, minimiert werden kann, um Beschädigungen des Substrates zu vermeiden.

Als Prozessgas kann für die Abscheidung quarzähnlicher Schichten dabei z.B. ein Gemisch aus Sauerstoff und einem gasförmigen siliziumorganischen Monomer wie Hexamethyldisiloxan (HMDSO), HMDSN, TEOS, TMOS, HMCTSO, APTMS, SiH4, TMS, OMCTS oder vergleichbarer Verbindungen, verwendet werden.

Analog können für die Abscheidung kohlenstoffhaltiger Schichten (sogenannte diamond like carbon "DLC" Schichten) C₂H₂, C₂H₄, CH₄, C₆H₆ oder andere kohlenstoffhaltige Quellsubstanzen im Prozessgas verwendet werden.

Zudem kann die Plasmaquelle linear, z.B. parallel und/oder transversal zur Schwerkraftrichtung, und/oder rotativ um die Längsachse und/oder eine Parallelachse des longitudinalen Düsenrohrelementes bewegbar sein.

Ebenso kann zudem der zu beschichtende Behälter relativ zur Plasmaquelle linear, z.B. parallel und/oder transversal zur Schwerkraftrichtung, und/oder rotativ um die Behälterlängsachse und/oder rotativ um eine zur Behälterlängsachse parallelen Achse bewegbar ist.

Es ist auch denkbar, dass der Behälter um eine andere Achse drehbar und/oder translativ bewegbar ist, die nicht parallel zur Schwerkraftrichtung oder Längsachse bzw. Parallelachse des longitudinalen Düsenrohrelementes ist.

Dies ermöglicht z.B. vorteilhafterweise, dass der Plasmaaustritt der Behälterkontur mit konstantem Abstand zur zu beschichtenden Behälterwand erfolgen kann.

Beschriebene Bewegungsgrade der Plasmaquelle und/oder eines zu beschichtenden Behälters bieten unter anderem den Vorteil, dass z.B. eine Plasmaquelle mit seitlichem/seitlichen Düsenrohrelement/en leichter in einen Behälter eingeführt werden kann und der Austritt des Plasmas aus einem Düsenrohrende nahe dem Substrat erfolgen kann, z.B. bevorzugt zwischen einem Abstand von Düsenrohrende und Substrat von 0.1 - 2 cm.

Ferner ist denkbar, dass die Düsenrohrenden beweglich sind, z.B. über steuerbare Elemente wie steuerbare Schwenkklappen verfügen, um Ausbreitungsrichtung und Austrittswinkel des austretenden Plasmas zu steuern, und z.B. den Austrittswinkel des Plasmas auf 30°bis 170°zu beschränken.

Dabei soll hier und im Allgemeinen unter dem Austrittswinkel des Plasmas, der Winkel zwischen Ausbreitungsrichtung des Plasmas und Längsachse des longitudinalen Düsenrohrelementes verstanden werden.

Es ist möglich, dass die Plasmaquelle eine Vielzahl von Düsenrohren und Elektroden aufweist. So kann z.B. die Plasmaquelle wenigstens ein longitudinales Düsenrohr mit Elektrode aufweisen, wobei sich das Düsenrohrende des longitudinalen Düsenrohrelementes am Ende der Plasmaquelle in Schwerkraftrichtung öffnen kann, sowie über eine Vielzahl von seitlichen Düsenrohrelementen mit Elektroden verfügen, die vom longitudinalen Düsenrohrelement seitlich in regelmäßigen oder unregelmäßigen Abständen abragen können. Das Plasma kann dabei durch die seitlichen Düsenrohrenden und durch das longitudinale Düsenrohrende austreten.

Das longitudinale Düsenrohr kann an seinem longitudinalen Ende aber auch verschlossen sein, so dass nur Plasma durch die seitlichen Düsenrohrenden austreten kann.

Als Elektroden, die in der Plasmaquelle eingesetzt werden können, können beispielsweise Stiftelektrode verwendet werden. Die Enden der Elektroden können unter anderem spitz zulaufen oder abgerundet sein.

Ferner ist es möglich eine erfindungsgemäße Vorrichtung zur plasmaunterstützen Beschichtung von Substraten als eine Rundläufervorrichtung mit einer Vielzahl von Behandlungseinheiten zur plasmaunterstützten Beschichtung von Behältern und/oder Behältervorformen auszuführen.

In einem erfindungsgemäßen Verfahren zur plasmaunterstützen Beschichtung eines Behälters, beispielsweise einer Kunststoffflasche, und/oder einer Behältervorform, z.B. eines Vorformlings, wird einer Plasmaquelle nach einem der Ansprüche 1 bis 9 Prozessgas zugeführt und das Prozessgas teilweise oder vollständig in ein Plasma umgesetzt. Dabei kann das Plasma am Ende wenigstens einer inneren Elektrode, an der eine Hochfrequenz anliegen kann, unter Umgebungsdruck, beispielsweise in einem Druckbereich von 800 bis 1200 hPa, und bei Temperaturen z.B. zwischen 10 und 50 °C, gezündet werden und durch ein Düsenrohrende des die innere Elektrode umgebenden Düsenrohrelementes austreten und ein Substrat, z.B. einen Behälter, wie beispielsweise eine Kunststoffflasche, und/oder eine Behältervorform, z.B. ein Vorformling, beschichten.

Es können auch in mehreren Beschichtungsschritten Schichten, bzw. mehrlagige Schichtsystem mit Schichten mit unterschiedlichen Zusammensetzungen und Schichteigenschaften abgeschieden werden, beispielsweise kann eine Zwischenschicht als Haftvermittler, z.B. Siliziumoxid mit Methylgruppenresten, zwischen dem Substrat, z.B. einer Kunststoffflasche, und der eigentlichen Beschichtung, z.B. eine Gasbarriereschicht, aufgetragen werden.

Beispielsweise kann zunächst eine Haftvermittlerschicht aus amorphem Kohlenstoff und anschließend eine Barriereschicht aus Siliziumoxid aufgetragen werden. DLC Schichten können in Abhängigkeit ihrer Schichtdicke als Barriereschichten, z.B. für Schichtdicken im Bereich von 50 bis 200 nm, oder als Haftvermittler, z.B. für Schichtdicken im Bereich von 1 bis 10 nm, aufgetragen werden.

Eine Barriereschicht kann zusätzlich mit einer Schutzschicht versehen/beschichtet werden, um sie z.B. vor chemischem Angriff durch das Produkt zu schützen. Alkalische oder auch nur schwach saure Produkte können beispielsweise eine SiOx-Schicht anlösen und beschädigen.

Zusätzliche funktionale Schichten für UV-Schutz, Abriebschutz, verbesserte Restentleerbarkeit durch Oberflächenmodifikation, Verringerung von "Gushing" (spontanes Aufschäumen nach der Druckentlastung beim Füllen oder beim Öffnen der Flaschen durch den Verbraucher), Oberflächenmodifikation zur Verbesserung der Beklebbarkeit (Etikett) oder die Direktbedruckung sind ebenfalls auftragbar.

Ebenso sind Beschichtungen mit sterilisierender Wirkung, z.B. Beschichtung mit Silberionen oder mit reaktiven Schichten z.B. Singulett-Sauerstoffhaltigen oder Singulett-Sauerstofferzeugenden Schichten denkbar.

Auch ein zusätzliches Auftragen von rein dekorativen Schichten zur Erzielung von Farb-, Matt-, Glanz- und Reflexionseffekten ist denkbar.

Darüber hinaus sind vorteilhafterweise z.B. auch "Sandwich"-Beschichtungen möglich, in der z.B. eine Barriereschicht zwischen zwei Haftvermittlungsschichten, oder zwischen einer Haftvermittlungsschicht und einer anderen funktionalen oder dekorativen Schicht liegt.

Auf diese Weise können vorteilhafterweise mehrlagige Beschichtungen mit Eigenschaften erzeugt werden, die sonst schwer vereinbar sind. Gute Sperrschichten sind z.B. meist spröde/brüchig und haften schlecht. Gut haftende Schichten hingegen haben oft entweder kaum Barrierewirkung ( z.B. "weiche" Siliziumoxidschichten), oder sie sind unerwünscht stark bräunlich eingefärbt (DLC-Schichten)

Es ist auch möglich in einem oder mehreren Beschichtungsschritten einen fließenden / kontinuierlichen Übergang in Schichtmaterial bzw. Schichtzusammensetzung und/oder Schichteigenschaften innerhalb einer Schicht oder zwischen verschiedenen Schichten zu erreichen. Beispielsweise kann eine Siliziumoxid-Schicht erzeugt werden die mit zunehmender Dicke härter wird.

Beigefügte Figuren stellen beispielhaft dar:
**Fig. 1****:** Plasmaquelle.
**Fig. 2****:** Alternative Plasmaquelle in Behälter.
**Fig. 3****:** Alternative Plasmaquelle in Behälter.
**Fig. 4****:** Alternative Plasmaquelle in Behälter.
**Fig. 5****:** Alternative Plasmaquelle in Behälter.

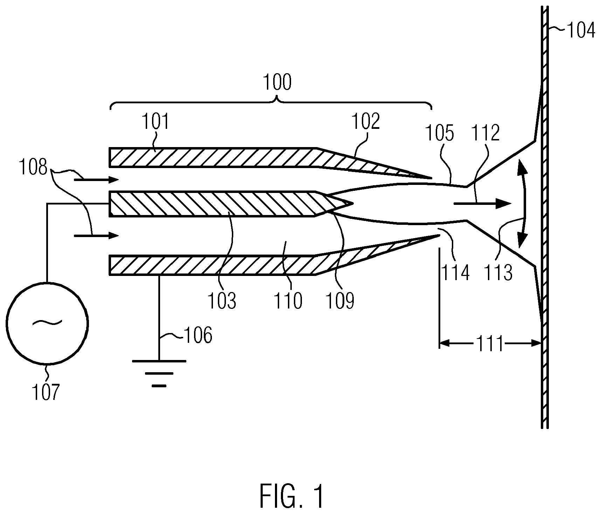

Die Figur 1 stellt beispielhaft das Schema einer Plasmaquelle 100 als Plasmadüse dar. Die Plasmaquelle kann dabei ein Düsenrohr 101 mit einem Düsenrohrende 102 aufweisen.

Das Düsenrohr 101 umfasst eine innere Elektrode 103, z.B. eine Stiftelektrode, an die eine Hochfrequenz aus der Hochfrequenzquelle 107 angelegt werden kann. Das Düsenrohr 101 kann dabei auf Masse bzw. Erdpotential 106 liegen. In den Hohlraum 110 zwischen innerer Elektrode und Düsenrohr 101 kann Prozessgas 108 zugeführt werden. Am Ende 109 der inneren Elektrode kann durch elektrische Entladungen das Prozessgas teilweise oder vollständig in ein Plasma 105 umgesetzt werden, und das Plasma 105 kann durch das Düsenrohrende 102 austreten und auf das zu beschichtende Substrat 104, z.B. eine Behälterwand oder Behältervorformoberfläche, treffen, welches sich in einem Abstand 111, bevorzugt 0.1 - 2 cm, vom Düsenrohrende 102 befinden kann. Das Düsenrohrende 102 kann dabei so geformt sein, dass es sich konisch zur Plasmaaustrittsöffnung 112 hin verjüngt.

Zudem ist es denkbar, dass das Düsenrohrende 102 steuerbare schwenkbare Klappen (nicht dargestellt) aufweisen kann, welche die Ausbreitungsrichtung 112 und den Austrittswinkel 113 des Plasmas regulieren können, in dem z.B. der Austrittswinkel 113 des Plasmas auf 30° bis 170° beschränkt werden kann.

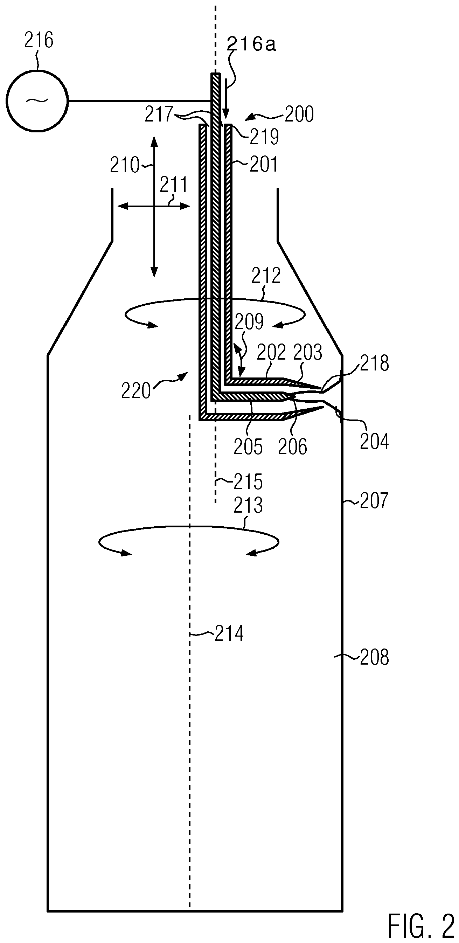

Die Figur 2 zeigt beispielhaft eine Plasmaquelle 200, die in einen Behälter 208 eingeführt werden kann. Die Plasmaquelle 200 besteht dabei aus einem longitudinalen Düsenrohrelement 201 und einem davon seitlich abragenden seitlichen Düsenrohrelement 202 mit Düsenrohrende 203. Der Winkel 209 zwischen seitlichem Düsenrohrelement 202 und longitudinalem Düsenrohrelement 201 kann zwischen 45° und 135° liegen. Bevorzugt ist ein Winkel 209 zwischen 80° und 100°, bzw. wie in Fig. 2 dargestellt von 90°.

Es ist dabei auch denkbar, dass das seitliche Düsenrohrelement 202 schwenkbar ist, beispielsweise mittels einer Kugelgelenkverbindung zwischen seitlichem Düsenrohrelement 202 und longitudinalem Düsenrohrelement 201. Dadurch kann ebenfalls die Ausbreitungsrichtung und der Austrittswinkel des Plasmas gesteuert werden, und z.B. der Austrittswinkel des Plasmas auf 30° bis 170 ° beschränkt werden.

Die innere Elektrode 205, die von den Düsenrohrelementen 201 und 202 umfasst werden kann und an die eine Hochfrequenz aus der Hochfrequenzquelle 216 angelegt werden kann, kann dabei dem geometrischen Verlauf der Kontur der Düsenrohrelemente 201 und 202 folgen.

Die Plasmaquelle kann dabei linear, z.B. parallel 210 und/oder transversal 211 zur Schwerkraftrichtung, und/oder rotativ um die Längsachse 215 und/oder eine Parallelachse 214 des longitudinalen Düsenrohrelementes bewegbar sein. Ebenso kann der Behälter 208 relativ zur Plasmaquelle 200 linear, z.B. parallel und/oder transversal zur Schwerkraftrichtung, und/oder rotativ um die Behälterlängsachse und/oder rotativ um eine zur Behälterlängsachse parallelen Achse 214 bewegbar sein.

Es ist auch denkbar, dass der Behälter 208 um eine andere Achse drehbar und/oder translativ bewegbar ist, die nicht parallel zur Schwerkraftrichtung oder Längsachse 215 bzw. Parallelachse 214 des longitudinalen Düsenrohrelementes ist.

Dies ermöglicht z.B. vorteilhafterweise, dass der Plasmaaustritt der Behälterkontur mit konstantem Abstand zur zu beschichtenden Behälterwand erfolgen kann.

Das Prozessgas 216a kann dem Hohlraum zwischen innerer Elektrode 205 und den Düsenrohrelementen 201 und 202 zugeführt werden, und sich am Ende 206 der Elektrode 205 teilweise oder vollständig in ein Plasma 204 umsetzen, welches durch die Plasmaaustrittsöffnung 218 am Düsenrohrende 203 austreten kann und somit z.B. eine Innenwand 207 des Behälters 208 beschichten kann.

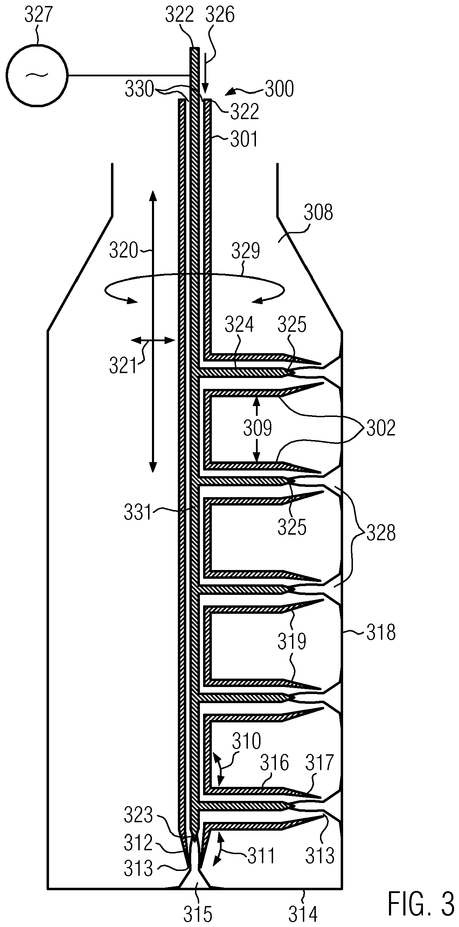

Die Figur 3 stellt beispielhaft eine weitere Plasmaquelle 300 dar, die in einen Behälter 308 eingeführt werden kann. Die Plasmaquelle 300 kann dabei über ein longitudinales Düsenrohrelement 301 verfügen, von dem eine Vielzahl seitlicher Düsenrohrelemente 302 seitlich abragen können. Die seitliche Düsenrohrelemente 302 können dabei an jeder Seite oder auch an mehreren Seiten entlang der Längsachse des longitudinalen Düsenrohres angebracht sein, wobei die vertikalen Abstände 309 benachbarter seitlicher Düsenrohrelemente 302 gleichmäßig oder unregelmäßig sein können, und z.B. zwischen 1 bis 4 cm, bevorzugt bei 2 cm liegen können.

Das Ende 312 in Schwerkraftrichtung des longitudinales Düsenrohrelement 301 kann ebenfalls als Düsenrohrende mit Plasmaaustrittsöffnung 313 ausgebildet sein, um vorteilhafterweise besser den Boden 314 des Behälters 308 mit dem austretenden Plasma 315 beschichten zu können. Besagtes longitudinales Düsenrohrende 312 kann mit dem unmittelbar benachbarten seitlichen Düsenrohrelement 316 z.B. einen Winkel 311 zwischen 45° und 135° bilden.

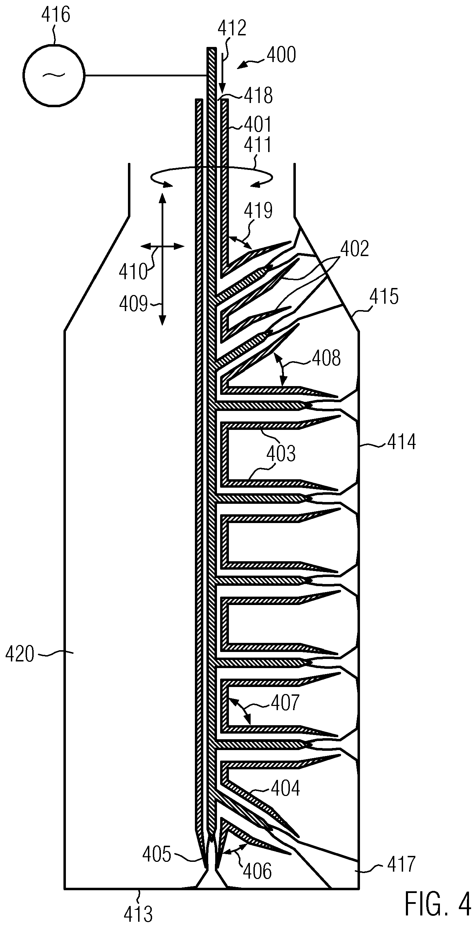

Wie dargestellt können die Winkel 310 zwischen seitlichen Düsenrohrelementen 302, 316 und longitudinalem Düsenrohrelement 301 z.B. rechtwinklig sein, aber auch zwischen 45° und 135° oder zwischen 80° und 100° liegen (siehe dazu auch Fig. 4).

Ebenso wie bei der bereits beschriebenen Plasmaquelle 200, kann die Plasmaquelle 300 dabei linear, z.B. parallel 320 und/oder transversal 321 zur Schwerkraftrichtung, und/oder rotativ 329 um die Längsachse und/oder eine Parallelachse oder unter einem Winkel zur Achse des longitudinalen Düsenrohrelementes 301 bewegbar sein. Ebenso kann der Behälter 308 relativ zur Plasmaquelle 300 linear, z.B. parallel und/oder transversal zur Schwerkraftrichtung, und/oder rotativ um die Behälterlängsachse und/oder rotativ um eine zur Behälterlängsachse parallelen Achse bewegbar sein.

Es ist auch denkbar, dass der Behälter 308 um eine andere Achse drehbar und/oder translativ bewegbar ist, die nicht parallel zur Schwerkraftrichtung oder Längsachse bzw. Parallelachse des longitudinalen Düsenrohrelementes 301 ist.

Das innere Elektrodenelement 322 kann aus einer Vielzahl von inneren Elektroden bestehen deren Anzahl gleich der Düsenrohrelemente sein kann, z.B. einer longitudinalen Elektrode 331, die vom longitudinalen Düsenrohrelement 301 umfasst wird, und den seitlichen Elektroden 324 die von den seitlichen Düsenrohrelementen 302, 316 umfasst werden.

Das Prozessgas 326 kann dem Hohlraum 330 zwischen innerem Elektrodenelement 322 und den Düsenrohrelementen 301, 302 und 316 zugeführt werden, und sich an den Enden 323, 325 der inneren Elektroden teilweise oder vollständig in ein Plasma 328 umsetzen, welches durch die Plasmaaustrittsöffnungen 313 der Düsenrohrendungen 312, 317, und 319 austreten kann und somit z.B. eine Innenwand 318 und/oder den Boden 314 des Behälters 308 beschichten kann.

Die Figur 4 stellt beispielhaft eine weitere Plasmaquelle 400 dar, die analog zur beschriebenen Plasmaquelle 300 aufgebaut ist, welche allerdings eine beispielhafte Anordnung der seitlichen Düsenrohrelemente 402, 403 und 404 zeigt, deren Orientierung zum longitudinalen Düsenrohrelement 401, charakterisiert durch die Winkel 406, 407, 408 zwischen longitudinalem Düsenrohrelement 401 und seitlichen Düsenrohrelementen 404, 403, 402 verschieden von 90° sein kann.

Beispielsweise kann der Winkel 406 zwischen longitudinalem Düsenrohrende 405 und benachbartem Düsenrohrende 404 kleiner als 90° sein, z.B. zwischen 10° und 85° liegen, und der Winkel 408 zwischen seitlichem Düsenrohr 402 und longitudinalem Düsenrohrelement 401 kann mehr als 90° betragen, und z.B. bei 95° bis 170° liegen.

Vorteilhafterweise können ein oder mehrere seitliche Düsenrohrelemente 402, 403, 404, die näher am Prozessgaseinlass 418 in das longitudinale Düsenrohrelement angeordnet sind, zu diesem Prozessgaseinlass 418 hingekippt sein (in Fig. 4 z.B. nach oben hin), d.h. der Winkel 419 zwischen seitlichem Düsenrohrelement 402 hin zum Prozessgaseinlass 418 des longitudinalen Düsenrohrelements 401 kann weniger als 90° betragen, und bevorzugterweise zwischen 10° und 85° liegen. Ein oder mehrere weiter vom Prozessgaseinlass 418 weg liegende seitliche Düsenrohrelemente können vom Prozessgaseinlass 418 weg (in Fig. 4 z.B. nach unten) gekippt sein.

Das hat unter anderem den Vorteil, dass z.B. die Beschichtung von Ecken, wie der Ecke 417 zwischen Behälterboden 413 und Behälterwand 414, oder von schrägen Behälterwänden, z.B. der Behälterwandschräge 415, erleichtert wird.

Abgesehen von den beschriebenen Winkeln, kann die Plasmaquelle 400 die gleichen Merkmale wie Plasmaquelle 300 aufweisen. So kann z.B. die Plasmaquelle 400 linear, z.B. parallel 409 und/oder transversal 410 zur Schwerkraftrichtung, und/oder rotativ 411 um die Längsachse und/oder eine Parallelachse des longitudinalen Düsenrohrelementes bewegbar sein. Ebenso kann der Behälter 420 relativ zur Plasmaquelle 400 linear, z.B. parallel und/oder transversal zur Schwerkraftrichtung, und/oder rotativ um die Behälterlängsachse und/oder rotativ um eine zur Behälterlängsachse parallelen Achse bewegbar sein.

Es ist auch denkbar, dass der Behälter 420 um eine andere Achse drehbar und/oder translativ bewegbar ist, die nicht parallel zur Schwerkraftrichtung oder Längsachse bzw. Parallelachse des longitudinalen Düsenrohrelementes 401 ist.

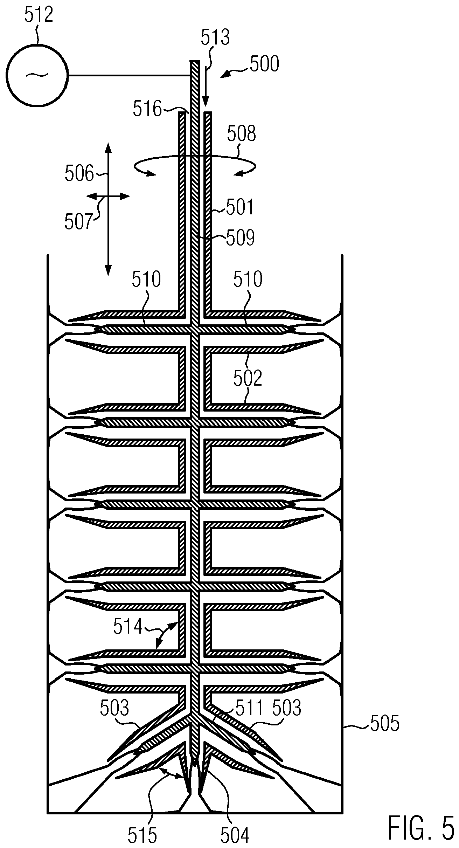

Die Figur 5 zeigt beispielhaft eine weitere Plasmaquelle 500, welche ein longitudinales Düsenrohrelement 501 aufweisen kann, von dem paarweise auf gegenüberliegenden Seiten des longitudinalen Düsenrohrelementes 501 seitliche Düsenrohrelemente 502, 503 seitlich abragen.

Die Winkel 515, 514 zwischen seitlichen Düsenrohrelemente 502, 503 und longitudinalem Düsenrohrelement 501 können zwischen 45° und 135° liegen, sind bevorzugterweise aber paarweise gleich. Der Winkel 515 zwischen dem longitudinalen Düsenrohrende 504 nächstgelegenen seitlichen Düsenrohrelementen 503, kann bevorzugterweise kleiner als 90° betragen und z.B. zwischen 10° und 85° liegen.

Wie bei den bereits beschriebenen Plasmaquellen 200, 300 und 400 kann die Plasmaquelle 500 linear, z.B. parallel 506 und/oder transversal 507 zur Schwerkraftrichtung, und/oder rotativ 508 um die Längsachse und/oder eine Parallelachse des longitudinalen Düsenrohrelementes bewegbar sein. Ebenso kann der Behälter 500 relativ zur Plasmaquelle 500 linear, z.B. parallel und/oder transversal zur Schwerkraftrichtung, und/oder rotativ um die Behälterlängsachse und/oder rotativ um eine zur Behälterlängsachse parallelen Achse bewegbar sein.

Es ist auch denkbar, dass der Behälter 500 um eine andere Achse drehbar und/oder translativ bewegbar ist, die nicht parallel zur Schwerkraftrichtung oder Längsachse bzw. Parallelachse des longitudinalen Düsenrohrelementes 501 ist.

Benachbarte Düsenrohrelemente können auch in der Höhe gegeneinander versetzt sein, und z.B. um das longitudinale Düsenrohrelement herum rotieren können.

Durch die erhöhte Anzahl der seitlichen Düsenrohrelemente im Vergleich zu einer nicht paarweisen Ausführung der seitlichen Düsenrohrelemente kann die in der gleichen Zeit beschichtbare Oberfläche erhöht und somit die benötigte Zeit für die Beschichtung reduziert werden. Eine weitere Optimierung der Beschichtungszeit wäre denkbar, durch eine weitere Erhöhung der seitlichen Düsenrohrelementenanzahl, z.B. seitlicher Düsenrohrelementkranz mit mehr als zwei seitlichen Düsenrohrelementen pro Kranz.

Darüber hinaus ist es denkbar, dass eine Plasmaquelle seitliche Düsenrohrelemente aufweist die teleskopartig und/oder schirmartig von einem longitudinalen Düsenrohr ausfahrbar und/oder ausklappbar sind.

Es folgen 5 Blatt mit 5 Figuren.

Die verwendeten Bezugszeichen sind dabei wie folgt belegt:
**100, 200, 300, 400, 500** Plasmaquelle
**101, 220** Düsenrohr
**201, 301, 401, 501** longitudinales Düsenrohrelement
**215** Längsachse eines longitudinalen Düsenrohrelements
**214** Längsachse eines Behälters oder Parallelachse zur Längsachse eines Behälters
**212, 329, 411, 508** Rotative Bewegung um Längsachse eines longitudinalen Düsenrohrelements
**213** Rotative Bewegung um Längsachse eines Behälters oder um einer zur Längsachse des Behälters parallele Achse
**202, 302, 316, 404, 403, 402 , 503, 502** seitliches Düsenrohrelement
**203** Seitliches Düsenrohrende
**102** Düsenrohrende
**203, 319, 317** seitliches Düsenrohrende, Düsenrohrende eines seitlichen Düsenrohrelements
**312, 405** longitudinales Düsenrohrende, Düsenrohrende eines longitudinalen Düsenrohrelements
**103, 205** Elektrode / innere Elektrode
**322** Elektrodenelement / Inneres Elektrodenelement
**331, 509** longitudinales Elektrodenelement
**324, 510, 511, 510** seitliches Elektrodenelement
**325** Elektrodenende eines seitlichen Elektrodenelements
**323** Elektrodenende eines longitudinalen Elektrodenelements
**309** Vertikaler Abstand zwischen benachbarten seitlichen Elektrodenelementen
**109, 206** Elektrodenende
**110, 217, 330** Hohlraum zwischen Düsenrohr bzw. Düsenrohrelement und Elektrode bzw. Elektrodenelement
**310, 407, 408, 514** Winkel zwischen seitlichem Düsenrohrelement und longitudinalem Düsenrohrelement
**311, 406, 515** Winkel zwischen longitudinalem Düsenrohrende mit einem unmittelbar benachbarten seitlichen Düsenrohrelement
**105, 204, 328, 315** Plasma
**112** Ausbreitungsrichtung des austretenden Plasmas
**113** Austritts-/Öffnungswinkel des austretenden Plasmas
**104** zu beschichtendes Substrat (z.B. ein Behälter, beispielsweise eine Kunststoffflasche, oder eine Behältervorform, z.B. eine Vorformling)
**208, 308, 420, 505** Behälter
**207, 318, 414** Innenwand eines Behälters
**314, 413** Bodenwand eines Behälters
**415** Behälterwandschräge
**417** Ecke zwischen Bodenwand und Innenwand eines Behälters
**114, 218, 313** Plasmaaustrittsöffnung
**111** Abstand zwischen Düsenrohrende und Substrat
**106** elektrische Erdung bzw. Massepotential
**107, 216, 327, 416, 512** Hochfrequenzquelle
**108,** 216a, **326, 412, 513** Prozessgas, Prozessgaszufuhr
**418, 332, 219, 516** Prozessgaseinlass
**210, 320, 409, 506** Bewegung parallel zur Schwerkraftrichtung
**211, 321, 410, 507** Bewegung transversal zur Schwerkraftrichtung

## Patentansprüche

1. Vorrichtung zur plasmaunterstützten Beschichtung eines Behälters, beispielsweise einer Kunststoffflasche, und/oder einer Behältervorform, z.B. eines Vorformlings, beinhaltend, wenigstens eine Hochfrequenzquelle (216), wenigstens eine Gaszufuhr zur Zufuhr von Prozessgas (216a), und wenigstens eine Plasmadüse als Plasmaquelle (200) aufweist, , wobei die Plasmaquelle eine innere Elektrode (205) aufweist, und die innere Elektrode (205) von einem Düsenrohr (220) umgeben ist, die wenigstens eine Plasmaquelle (200) in einen zu beschichtenden Behälter einführbar ist, und so konfiguriert ist, dass sie ein Plasma (204) unter Umgebungsdruck, beispielsweise in einem Druckbereich von 800 bis 1200 hPa, erzeugen kann, und das Plasma aus einem Düsenrohrende (203) austreten kann, und wobei die Temperatur des erzeugten Plasmas im Bereich der Umgebungstemperatur, z.B. zwischen 10 und 50 °C, liegt, **dadurch gekennzeichnet, dass** das Düsenrohr (220) der Plasmaquelle (200) ein longitudinales Düsenrohrelement (201) und ein seitliches Düsenrohrelement (202) aufweist, wobei das seitliche Düsenrohrelement (202) seitlich vom longitudinalen Düsenrohrelement (201) abragt, und Plasma durch das seitliche Düsenrohrende (203) austreten kann.

2. Vorrichtung nach Anspruch 1, **dadurch gekennzeichnet, dass** das Düsenrohrende ein steuerbares Element, z.B. eine steuerbare Schwenkklappe aufweist, mit der Ausbreitungsrichtung und Austrittswinkel des austretenden Plasmas gesteuert werden können, und z.B. der Austrittswinkel des austretenden Plasmas auf 30° bis 170° beschränkt werden kann.

3. Vorrichtung nach einem der vorigen Ansprüche, **dadurch gekennzeichnet, dass** die Plasmaquelle linear, z.B. parallel und/oder transversal zur Schwerkraftrichtung, und/oder rotativ um die Längsachse und/oder eine Parallelachse des longitudinalen Düsenrohrelementes bewegbar ist.

4. Vorrichtung nach einem der vorigen Ansprüche, **dadurch gekennzeichnet, dass** der zu beschichtende Behälter relativ zur Plasmaquelle linear, z.B. parallel und/oder transversal zur Schwerkraftrichtung, und/oder rotativ um die Behälterlängsachse und/oder rotativ um eine zur Behälterlängsachse parallelen Achse und/oder um eine Achse drehbar und/oder translativ bewegbar ist, die nicht parallel zur Schwerkraftrichtung oder Längsachse oder Parallelachse des longitudinalen Düsenrohrelementes ist, bewegbar ist

5. Vorrichtung nach einem der vorigen Ansprüche, **dadurch gekennzeichnet, dass** die Plasmaquelle eine Vielzahl von Düsenrohren und Elektroden aufweist.

6. Vorrichtung nach einem der vorigen Ansprüche, **dadurch gekennzeichnet, dass** die Plasmaquelle wenigstens ein longitudinales Düsenrohr mit Elektrode aufweist, und das Düsenrohrende des longitudinalen Düsenrohrelementes sich am Ende der Plasmaquelle in Schwerkraftrichtung öffnet, und eine Vielzahl von seitlichen Düsenrohrenelementen mit Elektroden aufweist, die vom longitudinalen Düsenrohrelement seitlich in regelmäßigen oder unregelmäßigen Abständen abragen, und Plasma durch die seitlichen Düsenrohrenenden und durch das longitudinale Düsenrohrenende austreten kann.

7. Vorrichtung nach Anspruch 6, **dadurch gekennzeichnet, dass** das longitudinale Düsenrohr an seinem longitudinalen Ende verschlossen ist.

8. Vorrichtung nach einem der vorigen Ansprüche, **dadurch gekennzeichnet, dass** das Ende der Elektrode(n) spitz zuläuft oder abgerundet ist.

9. Vorrichtung nach einem der vorigen Ansprüche, **dadurch gekennzeichnet, dass** die Vorrichtung als Rundläufer mit einer Vielzahl von Behandlungseinheiten zur plasmaunterstützten Beschichtung von Behältern und/oder Behältervorformen ausgebildet ist.

10. Verfahren zur plasmaunterstützten Beschichtung eines Behälters, beispielsweise einer Kunststoffflasche, und/oder einer Behältervorform, z.B. eines Vorformlings, welches folgende Schritte beinhaltet:
Erzeugung eines Plasmas in einer Plasmaquelle nach einem der Ansprüche 1 bis 9, unter Umgebungsdruck, beispielsweise in einem Druckbereich von 800 bis 1200 hPa, und bei Temperaturen z.B. zwischen 10 und 50 °C, und
Beschichtung eines Substrats, z.B. eines Behälters, beispielsweise einer Kunststoffflasche, und/oder einer Behältervorform, z.B. eines Vorformlings, mittels dem aus der Plasmaquelle austretenden Plasmas.

11. Verfahren nach Anspruch 10 bei dem das Substrat in mehreren Beschichtungsschritten mit Schichten von unterschiedlichen Zusammensetzungen und Schichteigenschaften beschichtet wird, beispielsweise wird in einer ersten Beschichtung eine Zwischenschicht als Haftvermittler, z.B. Siliziumoxid mit Methylgruppenresten, zwischen dem Substrat, z.B. einer Kunststoffflasche, vor einer zweiten Beschichtung, z.B. eine Gasbarriereschicht, aufgetragen.

12. Verfahren nach einem der Ansprüche 10 oder 11 bei dem das Substrat in einem oder mehreren Beschichtungsschritten beschichtet wird mit einem fließendem Übergang in Schichtmaterial bzw. Schichtzusammensetzung und/oder Schichteigenschaften innerhalb einer Schicht oder zwischen verschiedenen Schichten, z.B. mit einer mit zunehmender Dicke härter werdenden Siliziumoxid-Schicht.

## Claims

1. A device used for plasma-enhanced coating of a container, e.g. a plastic bottle, and/or a container blank, e.g. a container preform, and comprising at least one high-frequency source (216), at least one gas feed for feeding process gas (216a), and at least one plasma nozzle as plasma source (200), wherein the plasma source comprises an inner electrode (205) and said inner electrode (205) is surrounded by a nozzle tube (220), the at least one plasma source (200) is adapted to be introduced in a container to be coated and configured such that it is able to generate a plasma (204) under ambient pressure, e.g. in a pressure range of 800 to 1,200 hPA, and the plasma can be discharged from a nozzle tube end (203), and wherein the temperature of the generated plasma lies within the range of the ambient temperature, e.g. between 10 and 50 °C, **characterized in that** the nozzle tube (220) of the plasma source (200) comprises a longitudinal nozzle tube element (201) and a lateral nozzle tube element (202), said lateral nozzle tube element (202) projecting laterally from the longitudinal nozzle tube element (201), and plasma being dischargeable through the lateral nozzle tube end (203).

2. The device according to claim 1, **characterized in that** the nozzle tube end includes a controllable element, e.g. a controllable pivotable flap, by means of which the propagation direction and the discharge angle of the plasma discharged can be controlled, and e.g. the discharge angle of the plasma discharged can be limited to the range of 30° to 170°.

3. The device according to one of the preceding claims, **characterized in that** the plasma source is movable linearly, e.g. parallel and/or transversely to the direction of gravity, and/or rotatively about the longitudinal axis and/or a parallel axis of the longitudinal nozzle tube element.

4. The device according to one of the preceding claims, **characterized in that** the container to be coated is movable relative to the plasma source linearly, e.g. parallel and/or transversely to the direction of gravity, and/or rotatively about the longitudinal axis of the container and/or rotatively about an axis that is parallel to the longitudinal axis of the container and/or is rotatable about and/or translatively movable along an axis, which is not parallel to the direction of gravity or to the longitudinal axis or the parallel axis of the longitudinal nozzle tube element.

5. The device according to one of the preceding claims, **characterized in that** the plasma source comprises a plurality of nozzle tubes and electrodes.

6. The device according to one of the preceding claims, **characterized in that** the plasma source comprises at least one longitudinal nozzle tube with an electrode, the nozzle tube end of the longitudinal nozzle tube element opening at the end of the plasma source in the direction of gravity, and further comprises a plurality of lateral nozzle tube elements with electrodes which laterally project from the longitudinal nozzle tube element at regular or irregular intervals, and that plasma can be discharged through the lateral nozzle tube ends and through the longitudinal nozzle tube end.

7. The device according to claim 6, **characterized in that** the longitudinal nozzle tube is closed at its longitudinal end.

8. The device according to one of the preceding claims, **characterized in that** the end of the electrode(s) tapers or is rounded off.

9. The device according to one of the preceding claims, **characterized in that** the device is configured as a rotary machine comprising a plurality of treatment units for plasma-enhanced coating of containers and/or container blanks.

10. A method of plasma-enhanced coating of a container, e.g. a plastic bottle, and/or a container blank, e.g. a container preform, which comprises the following steps:
generating a plasma in a plasma source according to one of the claims 1 to 9, under ambient pressure, e.g. in a pressure range of 800 to 1,200 hPA, and at temperatures in a range of e.g. 10 to 50°C, and
coating a substrate, e.g. a container, e.g. a plastic bottle, and/or a container blank, e.g. a container preform, by means of the plasma discharged from the plasma source.

11. The method according to claim 10, comprising the steps of coating the substrate in a plurality of coating steps with layers having different compositions and layer characteristics, an intermediate layer being e.g. applied in a first coating step as an adhesive agent, e.g. silicon oxide with methyl group residues, between the substrate, e.g. a plastic bottle, and a subsequent second coating, e.g. a gas barrier layer.

12. A method according to one of the claims 10 or 11, comprising the steps of coating the substrate in one or a plurality of coating steps with a smooth transition in the layer material and/or the layer composition and/or the layer characteristics within one layer or between different layers, e.g. with a silicon oxide layer that becomes harder as the thickness increases.

## Revendications

1. Dispositif pour assurer le revêtement assisté par plasma d'un contenant, par exemple d'une bouteille plastique, et/ou d'une ébauche de moulage de contenant, par exemple une préforme, comprenant au moins une source de hautes-fréquences (216), au moins une alimentation en gaz pour l'amenée de gaz de processus (216a), et au moins une buse à plasma en tant que source de plasma (200), dispositif
dans lequel la source de plasma comporte une électrode intérieure (205), et l'électrode intérieure (205) est entourée par un tube de buse (220), ladite au moins une source de plasma (200) peut être introduite dans un contenant devant être revêtu, et est configurée de manière à pouvoir produire un plasma (204) sous pression environnante, par exemple dans une plage de pression de 800 à 1200 hPa, et le plasma peut sortir d'une extrémité de tube de buse (203), et
dans lequel là température du plasma produit se situe dans le domaine de la température environnante, par exemple entre 10 et 50 °C,
**caractérisé en ce que** le tube de buse (220) de la source de plasma (200) présente un élément de tube de buse longitudinal (201) et un élément de tube de buse latéral (202), l'élément de tube de buse latéral (202) faisant saillie latéralement de l'élément de tube de buse longitudinal (201), et du plasma pouvant sortir de l'extrémité de tube de buse latérale (203).

2. Dispositif selon la revendication 1, **caractérisé en ce que** l'extrémité de tube de buse comporte un élément pouvant être commandé, par exemple un clapet pivotant pouvant être commandé, à l'aide duquel il est possible de commander la direction de propagation et l'angle de sortie du plasma sortant, et de limiter par exemple l'angle de sortie du plasma sortant, à une valeur de 30° à 170°.

3. Dispositif selon l'une des revendications précédentes, **caractérisé en ce que** la source de plasma peut être déplacée linéairement, par exemple parallèlement et/ou transversalement à la direction de la gravité, et/ou de manière rotative autour de l'axe longitudinal et/ou d'un axe parallèle de l'élément de tube de buse longitudinal.

4. Dispositif selon l'une des revendications précédentes, **caractérisé en ce que** le contenant devant être revêtu peut être déplacé par rapport à la source de plasma, de manière linéaire, par exemple parallèlement et/ou transversalement à la direction de la gravité, et/ou de manière rotative autour de l'axe longitudinal du contenant et/ou de manière rotative autour d'un axe parallèle à l'axe longitudinal du contenant, et/ou peut être déplacé en translation et/ou rotation autour d'un axe qui n'est pas parallèle à la direction de la gravité ou à l'axe longitudinal ou à l'axe parallèle de l'élément de tube de buse longitudinal.

5. Dispositif selon l'une des revendications précédentes, **caractérisé en ce que** la source de plasma comprend une pluralité de tubes de buse et d'électrodes.

6. Dispositif selon l'une des revendications précédentes, **caractérisé en ce que** la source de plasma comprend au moins un tube de buse longitudinal avec électrode, et l'extrémité de tube de buse de l'élément de tube de buse longitudinal s'ouvre dans la direction de la gravité à l'extrémité de la source de plasma, et comporte une pluralité d'éléments de tube de buse latéraux avec électrodes, qui font saillie latéralement de l'élément de tube de buse longitudinal, selon des distances d'espacement régulières ou irrégulières, et du plasma peut sortir à travers les extrémités de tube de buse latérales et à travers l'extrémité de tube de buse longitudinale.

7. Dispositif selon la revendication 6, **caractérisé en ce que** le tube de buse longitudinal est fermé à son extrémité longitudinale.

8. Dispositif selon l'une des revendications précédentes, **caractérisé en ce que** l'extrémité de l'électrode ou des électrodes se termine en pointe ou est arrondie.

9. Dispositif selon l'une des revendications précédentes, **caractérisé en ce que** le dispositif est réalisé sous la forme d'une table tournante avec une pluralité d'unités de traitement pour assurer le revêtement assisté par plasma de contenants et/ou d'ébauches de moulage de contenants.

10. Procédé pour assurer le revêtement assisté par plasma d'un contenant, par exemple d'une bouteille plastique, et/ou d'une ébauche de moulage de contenant, par exemple une préforme, comprenant les étapes suivantes :
production d'un plasma dans une source de plasma selon l'une des revendications 1 à 9, sous pression environnante, par exemple dans une plage de pression de 800 à 1200 hPa, et à des températures par exemple entre 10 et 50 °C, et
revêtement d'un substrat, par exemple d'un contenant, par exemple d'une bouteille plastique, et/ou d'une ébauche de moulage de contenant, par exemple une préforme, à l'aide du plasma sortant de la source de plasma.

11. Procédé selon la revendication 10, d'après lequel le substrat est revêtu en plusieurs étapes de revêtement, avec des couches de compositions et de propriétés de couche différentes, par exemple en appliquant au cours d'un premier revêtement, une couche intermédiaire en tant qu'agent de pontage, par exemple de l'oxyde de silicium avec des restes de groupes méthyle, entre le substrat, par exemple une bouteille plastique, et un deuxième revêtement effectué ensuite, par exemple une couche formant barrière aux gaz.

12. Procédé selon la revendication 10 ou la revendication 11, d'après lequel le substrat est revêtu en une ou plusieurs étapes de revêtement avec une transition fluide concernant le matériau de couche respectivement la composition de couche et/ou les propriétés de couche, à l'intérieur d'une couche ou entre différentes couches, par exemple avec une couche d'oxyde de silicium de dureté croissante lorsque l'épaisseur augmente.
